# EUROPÄISCHE PATENTSCHRIFT

(11) **EP 0 992 058 B1**
(45) Veröffentlichungstag und Bekanntmachung des Hinweises auf die Patenterteilung: **13.08.2003**
(21) Anmeldenummer: 98928283.5
(22) Anmeldetag: 16.05.1998
(51) Int. Cl.: H01J 37/32

(54) **VORRICHTUNG ZUR ERZEUGUNG VON HOMOGENEN MIKROWELLENPLASMEN**
DEVICE FOR THE PRODUCTION OF HOMOGENOUS MICROWAVE PLASMA
DISPOSITIF POUR LA PRODUCTION DE PLASMAS HYPERFREQUENCES HOMOGENES

(30) Priorität: 23.06.1997 DE 19726663
(43) Veröffentlichungstag der Anmeldung: 12.04.2000
(73) Patentinhaber: Sung-Spitzl, Hildegard, 53639 Königswinter (DE)
(72) Erfinder: Sung-Spitzl, Hildegard, 53639 Königswinter (DE)
(74) Vertreter: Flaccus, Rolf-Dieter, Dr.
(86) Internationale Anmeldenummer: EP9802897
(87) Internationale Veröffentlichungsnummer: WO98059359

(56) Entgegenhaltungen:
- EP-A- 0 335 675
- EP-A- 0 564 359
- EP-A- 0 827 182
- EP-A- 0 880 164
- EP-A- 0 885 455
- WO-A-96/21751
- DE-A- 19 608 949
- US-A- 5 520 740
- PATENT ABSTRACTS OF JAPAN vol. 006, no. 011 (C-088), 22. Januar 1982 & JP 56 136646 A (TOSHIBA CORP), 26. Oktober 1981

## Beschreibung

Plasmen von verschiedener Art werden nach zahlreichen Verfahren mit verschiedenartigen Vorrichtungen erzeugt. Die Plasmabehandlung dient z.B. der Beschichtung, Reinigung, Modifizierung und Ätzung von Substraten, zur Behandlung von medizinischen Implantaten, zur Umsetzung von Gasen sowie in der Technik zur Abgasreinigung. Die Geometrie der zu behandelnden Werkstücke reicht von flachen Substraten, Fasern, Bahnen bis zu Formteilen von beliebiger Gestalt. Die Größe der Plasmakammer und damit der Werkstücke ist begrenzt. Bahnförmige Materialien und Faserbündel sind nur schwer bearbeitbar.

Bekannte Vorrichtungen besitzen für die Zuleitung der Mikrowellen u.a. Hohlleiter und Koaxialkabel, als Koppelstellen in der Wand der Plasmakammer werden u.a. Antennen oder Schlitze verwendet.

EP-A-0 564 359 beschreibt Vorrichtungen zur Erzeugung von Mikrowellenplasmen, bei denen die Einleitung der Mikrowellen über hohlringförmige Resonatoren von rechteckigem Querschnitt erfolgt. Bei Resonanz bilden sich in diesen Hohlringen in sich geschlossene Ringmoden. Eine Plasmakammer kann im Innenraum des Hohlrings oder auf dessen Außenseite angeordnet sein; die Homogenität der Mikrowellen nimmt aber mit der Entfernung vom Ring ab.

DE-A-196 08 949 (nicht vorveröffentlicht) und EP-A-0 885 455 (Anmeldung gemäß Artikel 54 (3) EPÜ) betreffen Vorrichtungen zur Erzeugung von Mikrowellenplasmen mit Mikrowellenerzeuger, Resonator mit Koppelstellen, Plasmakammer und ggf. Rezipienten. Der Mikrowellen-zuleitende Resonator ist als Koaxialresonator mit Innen- und Außenleiter ausgebildet. Die Plasmakammer ist vom zuleitenden Resonator ganz oder teilweise umfaßt, oder der Resonator ist von der Plasmakammer ganz oder teilweise umfaßt. Die Mikrowellen werden beispielsweise über Koppelschlitze in die Plasmakammer eingekoppelt; diese können in oder an der gemeinsamen Wand von Plasmakammer und Resonator ausgebildet sein.

US-A-5 520 740 beschreibt ein kontinuierliches Mikrowellenplasma-CVD-Verfahren, bei dem eine zu behandelnde Folienbahn in Form einer Schlaufe an einem Mikrowellenapplikator vorbeigeführt wird; dieser befindet sich unterhalb der nach unten offenen Schlaufe der Folienbahn. Der Mikrowellenapplikator ist ein Hohlleiter von zylindrischer Gestalt, mit einer Öffnung versehen und von einer Isolierschicht aus dielektrischem Material umgeben. Der Applikator ist kein Resonator, da er ein offenes Ende besitzt und nicht abgeschlossen ist. Die Ausbildung von stehenden Wellen soll auf diese Weise vermieden werden. Eine Plasmakammer ist nicht vorhanden; die Mikrowellenenergie wird in den Innenraum der Folienbahnschlaufe abgestrahlt, und zwar mittels einer oder mehrerer verschließbarer Öffnungen, die sich über die gesamte Länge des Applikators erstrecken. Diese bekannten Vorrichtungen bzw. Verfahren eignen sich nur für die Behandlung elektrisch leitfähiger Substrate.

Bei der Vorrichtung EP-A-0 335 675 gibt es nur eine Kammer, mit darin angeordnetem, auf einer Seite offenem Wellenleiter von rechteckigem Querschnitt, den eine teils zylindrisch gestaltete dielektrische Wand aus Quarz umgibt.

Nachteil der bekannten Vorrichtungen sind die Bildung von Inhomogenitäten im Plasma besonders bei hohen Drücken und größeren Plasmakammern bzw. Substraten.

Es bestand daher die Aufgabe, eine vielseitig verwendbare Vorrichtung zur Erzeugung von Mikrowellenplasmen zu schaffen, mit welcher eine homogene Plasmabehandlung von Substraten, insbesondere von bahnförmigen Materialien in nahezu beliebiger Breite, ermöglicht wird.

Die Aufgabe wird dadurch gelöst, daß bei Vorrichtungen mit den im Oberbegriff des Anspruchs 1 genannten Merkmalen die zuleitende Kammer (2) ein Resonator ist, der (a) entweder als Zylinderresonator ausgeführt ist, oder (b) als gebogenes oder geschwungenes Rohr mit konstantem oder veränderlichem Durchmesser ausgebildet ist; und daß die Plasmakammer (3) den zuleitenden Resonator (2) ganz oder teilweise umschließt. Die Aufgabe wird ferner durch die in den abhängigen Ansprüchen beschriebenen bevorzugten Ausführungsformen gelöst.

Die Stirnflächen der Kammer (2) sind bevorzugt nicht von der Plasmakammer (3) umfaßt, wobei die Plasmakammer (3) die Zylinderwand der Kammer (2) ganz oder teilweise umfaßt.

Die gemeinsame Wand zwischen Kammer (2) und Kammer (3) ist vorteilhaft gänzlich, teils oder wesentlich zylindrisch auszubilden. Die äußere Wand der Plasmakammer (3) ist zylindrisch oder beliebig, z.B. der Art der Bearbeitung angepaßt, gestaltet. Die Ausbildung der Plasmakammer (3) als Resonator, z.B. als Koaxial-, Rechteck- oder ringförmiger Resonator ist möglich. Als ringförmiger Resonator kann die Plasmakammer (3) bei rechteckigem Querschnitt mit der schmalen oder langen Seite die gemeinsame Wand mit Kammer (2) bilden. Die Plasmakammer kann auch als Segment der genannten Formen ausgebildet sein.

Die Plasmakammer (3) und die zylindrische Kammer (2) haben bevorzugt eine gemeinsame Vorzugsrichtung und im einfachsten, vielfach bevorzugten Falle eine gemeinsame z- Achse. Bevorzugt ist weiter die rotationssymmetrische Ausbildung der Kammer (2) zumindest auf Teilen, besonders den Teilen nahe der Stirnflächen. Zwei ineinander angeordnete Rohre mit gemeinsamer z-Achse sind die konstruktiv einfachste, überraschende, und vielfach bevorzugte Anordnung der Kammern (2) und (3).

Die Kammern (2) und (3) können entlang der Vorzugsrichtung oder Achse gleich oder verschieden lang ausgebildet sein.

Die Zylinderform der Kammer (2) erlaubt, auch durch einfache geometrische Gestalt eine verbesserte Gleichmäßigkeit der Mikrowelleneinkopplung und einfache Ausbildung der Kammern (2) und (3) als Resonatoren. Die Zylinderform der Kammer (2) erlaubt zudem eine bisher nicht mögliche Variation, Veränderbarkeit und Einstellbarkeit der Gestalt und der Wirksamkeit und der Resonanz von Kammer (2) und auch der Plasmakammer (3). Hierzu kann mindestens eine der Stirnflächen der Kammer (2) beweglich bzw. verschiebbar angeordnet sein. Weiter kann mindestens eine der Stirnflächen der Plasmakammer (3) beweglich bzw. verschiebbar angeordnet sein. Verschiebung in Vorzugsrichtung und / oder Drehung der Stirnflächen (4) bzw. (5) ist besonders einfach möglich. Hierzu besitzen die Stirnflächen an der Zylinderwand anliegende Halterungen, Rohrstutzen oder dergleichen. Die Rohrstutzen können Aussparungen aufweisen und über kleine oder erhebliche Teile der Zylinderwand, an der Zylinderwand anliegend, ausgebildet sein. Dann können die Koppelstellen variabel, beweglich, einstellbar angeordnet, abdeckbar oder durch Öffnen einschaltbar gestaltet sein. Die Zylinderwand ist dann dadurch, ganz oder teilweise, doppelt bzw. dreifach ausgebildet.

Nach einer bevorzugten Ausführungsform ist vorgesehen, daß die gemeinsame Wand zwischen zuleitender Kammer (2) und Plasmakammer (3) ganz oder teilweise mehrfach ausgebildet ist und mindestens eine der dadurch gebildeten Wände der gemeinsamen Wand mit den dort befindlichen Koppelstellen (6) variabel verschiebbar oder/und drehbar angeordnet ist. Mindestens eine der dadurch gebildeten Wände der gemeinsamen Wand mit den dort befindlichen Koppelstellen kann mit einer variabel verschiebbar oder/und drehbar angeordneten Stirnfläche der zuleitenden Kammer (2) und/oder der Plasmakammer (3) verbunden sein.

Bewegliche Koppelstellen können mit Hilfe der Stirnflächen oder durch z.B. Griffe unabhängig von Stirnflächen beweglich angeordnet sein. Die zuleitende bzw. einkoppelnde Kammer (2) hat in vielen Fällen bevorzugt ideale bzw. im wesentlichen Zylinderform und als Koppelstellen z.B. azimutale Schlitze. Die Stirnflächen sind dann kreisförmig bzw. die Kontaktfläche mit der Zylinderwand ist ein Kreis und die zu- bzw. wegschaltbaren Schlitze sind durch die Stirnfläche bzw. von außen bewegbar.
Die zuleitende Kammer (2) kann auch von der Idealform eines Zylinders abweichen, z.B. einen elliptischen oder eckigen z. B. dreieckigen bis sechseckigen Querschnitt ganz oder teilweise aufweisen. Auch eine um die z-Richtung geschwungene Form ist möglich. Der Zylinder der Kammer (2) kann gebogen sein. Beide Stirnflächen können sich berühren. Bevorzugt ist die vielfach entlang der z-Richtung linear gestreckte Form der Kammer (2).
Die Plasmakammer kann Zuführung für Gase und Vorrichtung für die Evakuierung auf weisen. Die Vorrichtung der Erfindung ist vielseitig verwendbar, besonders ist aber die Behandlung bahnförmiger Materialien in nahezu beliebiger Breite möglich.

Zur Erzeugung eines Vakuums kann die Plasmakammer einen (in der Zeichnung nicht gezeigten) Rezipienten, der ganz oder teilweise aus dielektrischem Material mit vorzugsweise geringen dielektrischen Verlusten, z.B. Quarzglas oder Aluminiumoxid-Keramik besteht, enthalten. Im Falle der Ausbildung der Plasmakammer als Koaxialresonator kann der Rezipient mit Hilfe eines dielektrischen Rohres z.B. aus Quarzglas, welches über den Zylinderresonator gestülpt ist, ausgeführt werden. Hierbei bildet das dielektrische Rohr zusammen mit dem Außenleiter des Koaxialresonators und dessen Stirnflächen den Vakuumrezipienten. Im Falle des Betriebes der Vorrichtung bei höheren Drücken z.B. Atmosphäre verhindert der Rezipient die Ausbildung eines Plasmas an den Koppelstellen bzw. in der zuführenden zylinderförmigen Kammer, deren Zuleitung oder auch am Mikrowellenerzeuger selbst. Der Plasmabereich der Vorrichtung kann aber ebenso durch die Einbringung dielektrischen Materials gezielt auf die gewünschten Bereiche eingeschränkt werden. So kann z.B. durch Auskleidung des Bereiches um die Koppelstelle und der Koppelstellen selbst durch dielektrisches Material die Entstehung eines Plasma in diesem Bereich verhindert werden. Wird die Plasmakammer als Koaxialresonator ausgeführt, so ist deren Ausbildung als TEM-Resonator bevorzugt. Jedoch sind auch andere Modea wie z.B. TE- oder TM-Moden möglich. Bei der Behandlung von bahnförmigen Materialien wie z.B. Kunststoff- oder Stoffbahnen ist eine Zuführung bzw. Abführung des zu behandelnden Materials durch Schlitze im Außenleiter des TEM Koaxialresonators z.B. entlang der z-Achse möglich, ohne durch diese Mikrowellenleistung nach außen zu koppeln. Eine Ausführung der zuführenden zylinderförmigen Kammer als TM010 Resonator mit azimuthalen Schlitzkopplern ist hierbei bevorzugt. Der Abstand der Schlitzkoppler in z-Richtung ist hierbei bevorzugt eine Wellenlänge der verwendeten Mikrowelle. Mehrere um den Umfang des Zylinderresonators verteilt und aus der azimuthalen Richtung in Richtung z-Achse um z.B. 45 Grad verkippte Schlitze sind ebenso möglich. Hierbei ist auch eine Anordnung von Schlitzreihen in einem Abstand der halben Wellenlänge ausführbar, wobei die Kipprichtung der Schlitze von einer zur nächsten Schlitzreihe entgegengesetzt sein sollte.

Die Einkopplung der Mikrowellen in die Plasmaquelle kann mit den bekannten abstiminbaren Zuleitungen über eine Wandung der Kammern erfolgen; bevorzugt über eine Stirnwand oder Kammerwand, wobei die Abstimmung der Plasmaquelle ganz oder teilweise durch Einstellung in und durch eine Kammerwand erfolgt. Die Abstimmung kann auch über die bekannten Abstimmelemente erfolgen.

Alle Teile der Vorrichtungen können mehrfach vorhanden sein.

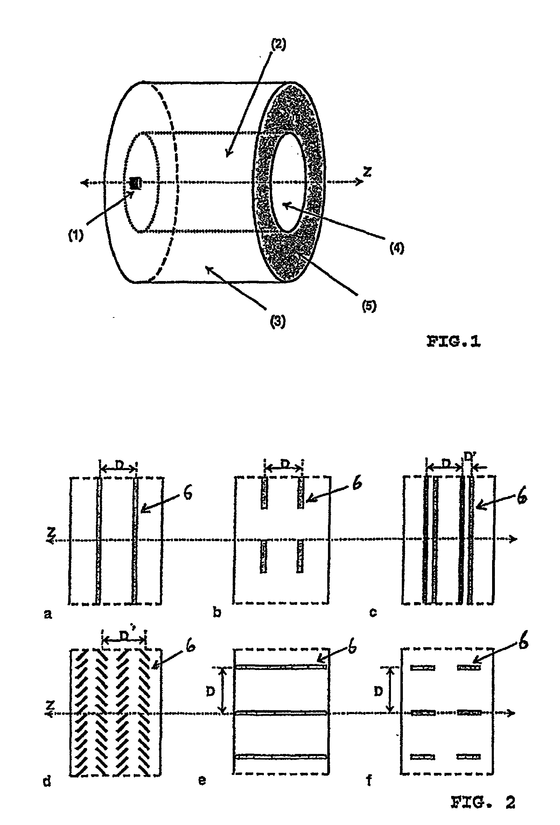

In der Zeichnung zeigt Fig. 1 eine Vorrichtung mit zylinderförmiger zuleitender Kammer (2), umgeben von der Plasmakammer (3) mit Mikrowellenerzeuger (1) in einer Stirnfläche der Kammer (2). Die Stirnflächen (4) der Kammer (2) und die Stirnflächen (5) der Plasmakammer (3) liegen in diesem Fall in einer Ebene.

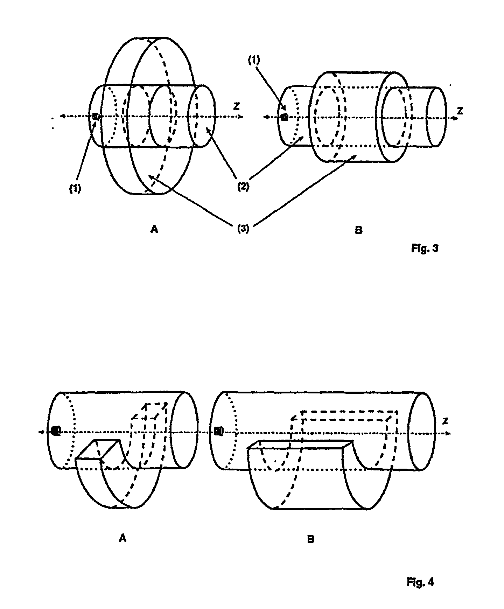

Fig. 2 zeigt Abwicklungen der Mantelflächen der zylindrischen Kammer (2) mit Koppelstellen in der Wand zu der Plasmakammer (3). Fig. 2a zeigt azimuthal umlaufende Schlitzkoppler mit Abstand D von bevorzugt einer bzw. einer halben Wellenlänge bei Resonanz. Fig. 2.b zeigt azimuthale Schlitzkoppler mit Abstand D von gleicher Phase, die den Umfang der Zylinderfläche nur teilweise abdecken. Fig. 2c zeigt zwei Paare von azimuthalen Schlitzkopplern mit Abstand D, die um D' von z.B. einer viertel Wellenlänge zueinander verschoben sind. Durch mechanische Verschiebung der Stirnflächen (4) und/oder (5) um D' in Richtung der z-Achse erfolgt Kopplung durch beide oder nur ein Schlitzpaar. Die Schlitze müssen nicht mit verschoben werden. Bei nur einer Schlitzreihe müssen Stirnflächen und Schlitze verschoben werden, um die Homogenisierung zu erreichen. Ein Schlitzpaar ist mit einer Halterung mit der Stirnfläche (5) verbunden und wird durch deren Bewegung in z-Richtung verschoben. Die Stirnflächen (4) der Kammer (2) werden verschoben, bis Resonanz erreicht ist. Fig. 2d zeigt zwei Paare von Reihen von Schlitzkopplern mit gegensätzlicher Kipprichtung vom Abstand jeweils D und halben Abstand D zueinander, wodurch gleichphasige Einkopplung in die Plasmakammer d.h. die entgegengesetzte Flußrichtung der Wandströme durch gegensätzliche Kopplung der Schlitzreihen im Abstand von z.B. der halben Resonatorwellenlänge genutzt wird. Zusätzliche Schlitzreihen im Abstand von z.B. einer viertel Wellenlänge sind möglich. Schlitzreihen können , wie in Fig. 2c, verschoben werden.

Fig. 2e und Fig. 2f zeigt mehrere Koppel schlitze, die parallel der z-Achse verlaufen und z.B. durch Drehung und/oder Schieben der Stirnfläche (5) veränderbar sind. In Fig. 2f sind die Schlitze unterbrochen. Anstelle von Schlitzen sind anderer Koppelelemente verwendbar.

Fig. 3 zeigt eine Vorrichtung mit Plasmakammer (3) in der bevorzugten Ausbildung als ringförmigen Resonator von rechteckigem Querschnitt, wobei über eine kurze Rechteckseite (3A) oder eine lange Rechteckseite (3B) die Mikrowelleneinkopplung aus (2) erfolgt.

Fig. 4 gleicht Fig. 3, jedoch ist Kammer (2) von einer Plasmakammer (3) umschlossen, die als 180° Zylindersegment ausgebildet ist.

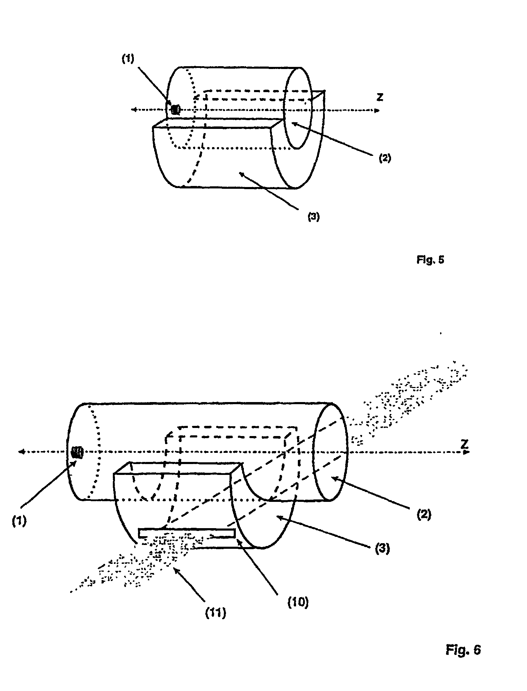

Fig. 5 zeigt die zuleitende Kammer (2), umgeben von der Plasmakammer (3), die in z-Richtung gleichlang wie Kammer (2) und als 180° Segment ausgebildet ist.

Fig. 6 zeigt eine lange Kammer (2) umgeben von längerer als 180° Segment ausgebildeten Kammer (3), durch welche ein zu behandelndes bahnförmiges Substrat (11) durch den Schlitz (10) kontinuierlich bewegt wird. Der Austrittsschlitz ist nicht dargestellt.

Fig. 7 zeigt zwei Vorrichtungen I und II zur Behandlung eines bahnförmiges Substrats 11 nach wahlweise gleichen oder verschiedenen Verfahren, wobei das bahnförmige Substrat durch die jeweiligen Schlitze. 10a und 10b nacheinander geführt wird.

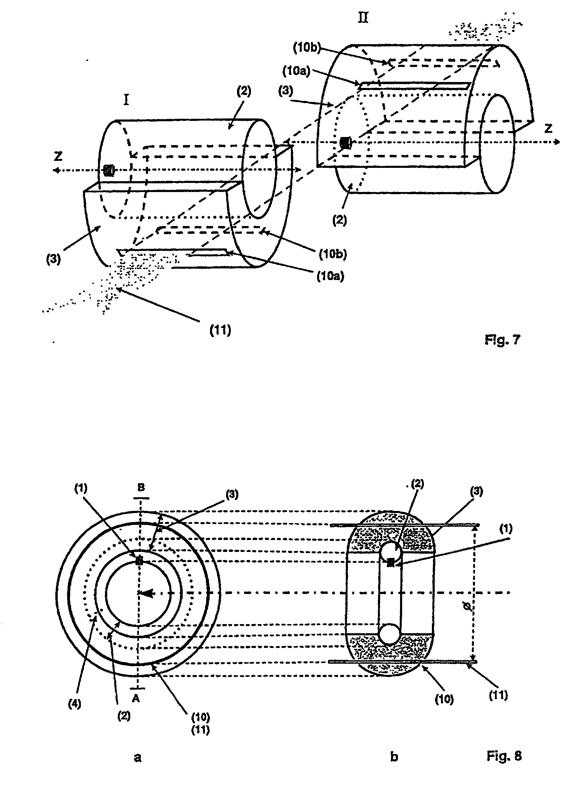

Fig. 8 zeigt eine Vorrichtung zur kontinuierlichen Bearbeitung von Rohren (11) die kontinuierlich senkrecht zur Zeichenebene der Fig. 8a durch Ringschlitze (10) durch die Plasmakammer (3) geführt sind. Das zu bearbeitende Rohr hat stets den gleichen Abstand zu den nicht gezeigten Koppelelementen der ringförmigen zuleitenden Kammer (2), deren Mittellinie (4) in Form eine Kreises durch gedachte konstante Krümmung der zylindrischen Achse entsteht. Kammer (2) besitzt in Fig. 8a eine kreisförmigen Querschnitt, kann jedoch auch gekrümmt ovalen oder auch eckigen Querschnitt haben. Fig. 8b zeigt eine Schnitt durch die Vorrichten entsprechend der Schnittlinie AB in Fig. 8a. Die Plasmakammer (3) ist als 180° Segment eines Kreisringes außen um den Ring der Kammer (2) angeordnet, daß das äußere 180° Segment der Kammer (2) mit Koppelelementen versehbar ist. Der Halbkreis des Querschnitts der Kammer (3) kann auch als Rechteck ausgebildet sein.

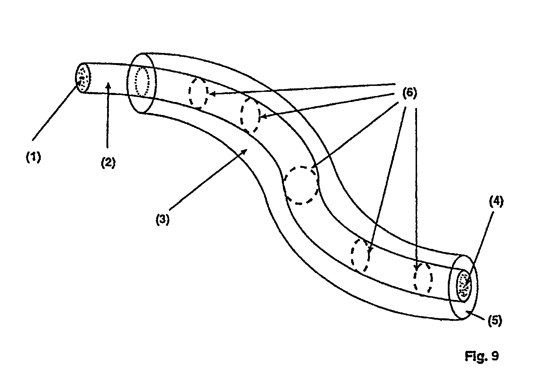

Fig. 9 zeigt eine Vorrichtung mit koaxialen Kammern (2) und (3) , die in geometrischer Anpassung an z.B. Substrate einer gekrümmten (nicht gezeigten) Achse folgen. In der Ebene der anzimutalen Schlitzkoppler (6) können die Querschnitte kreisförmig oder z.B. elliptisch, von konstantem oder nicht konstantem Durchmesser entlang der gekrümmten Achse sein.

## Patentansprüche

1. Vorrichtung zur Erzeugung von Mikrowellenplasmen, mit Mikrowellenerzeuger (1), Plasmakammer (3) und zuleitender Kammer (2) mit Koppelstellen (6) in der Wand zwischen zuleitender Kammer (2) und Plasmakammer (3), wobei die Mikrowellen vom Mikrowellenerzeuger (1) über die zuleitende Kammer (2) und über die genannten Koppelstellen (6) in die Plasmakammer (3) eingeführt werden, **dadurch gekennzeichnet, daß** die zuleitende Kammer (2) ein Resonator ist, der
(a) entweder als Zylinderresonator ausgeführt ist, oder
(b) als gebogenes oder geschwungenes Rohr mit konstantem oder veränderlichem Durchmesser ausgebildet ist;
und daß die Plasmakammer (3) den zuleitenden Resonator (2) ganz oder teilweise umschließt.

2. Vorrichtung nach Anspruch 1, **dadurch gekennzeichnet, daß** die zuleitende Kammer (2) ein Zylinder oder Rohr mit rundem, elliptischem oder eckigem Querschnitt ist.

3. Vorrichtung nach Anspruch 1 oder 2, **dadurch gekennzeichnet, daß** zuleitende Kammer (2) und Plasmakammer (3) entlang einer gemeinsamen Achse gleich lang ausgebildet sind.

4. Vorrichtung nach Anspruch 1 oder 2, **dadurch gekennzeichnet, daß** zuleitende Kammer (2) und Plasmakammer (3) entlang einer gemeinsamen Achse verschieden lang ausgebildet sind.

5. Vorrichtung nach einem der Ansprüche 1 bis 4, **dadurch gekennzeichnet, daß** mindestens eine der Stirnflächen der zuleitenden Kammer (2) und/oder der Plasmakammer (3) variabel verschiebbar oder/und drehbar angeordnet ist.

6. Vorrichtung nach einem oder mehreren der Ansprüche 1 bis 5, **dadurch gekennzeichnet, daß** die gemeinsame Wand zwischen zuleitender Kammer (2) und Plasmakammer (3) ganz oder teilweise mehrfach ausgebildet ist und mindestens eine der dadurch gebildeten Wände der gemeinsamen Wand mit den dort befindlichen Koppelstellen (6) variabel verschiebbar oder/und drehbar angeordnet ist.

7. Vorrichtung nach Anspruch 6, **dadurch gekennzeichnet, daß** mindestens eine der dadurch gebildeten Wände der gemeinsamen Wand mit den dort befindlichen Koppelstellen (6) mit einer variabel verschiebbar oder/und drehbar angeordneten Stirnfläche der zuleitenden Kammer (2) und/oder der Plasmakammer (3) verbunden ist.

8. Vorrichtung nach einem oder mehreren der vorangehenden Ansprüche, **dadurch gekennzeichnet, daß** die Plasmakammer (3) als Resonator, vorzugsweise als Koaxial-, Rechteck- oder ringförmiger Resonator ausgebildet ist.

9. Vorrichtung nach einem oder mehreren der vorangehenden Ansprüche, **dadurch gekennzeichnet, daß** die Koppelstellen (6) variabel, beweglich, einstellbar, abdeckbar oder durch öffnen einschaltbar gestaltet sind.

10. Vorrichtung nach einem oder mehreren der vorangehenden Ansprüche, **dadurch gekennzeichnet, daß** die Koppelstellen (6) als Schlitze gestaltet sind, vorzugsweise in paarweiser oder reihenförmiger Anordnung.

11. Vorrichtung nach einem der vorangehenden Ansprüche, **dadurch gekennzeichnet, daß** die Plasmakammer (3) einen evakuierbaren Rezipienten enthält, der ganz oder teilweise aus dielektrischem Material besteht.

12. Vorrichtung nach einem oder mehreren der vorangehenden Ansprüche, **dadurch gekennzeichnet, daß** die Plasmakammer (3) einen oder mehrere Schlitze aufweist, durch welchen ein zu behandelndes bahnförmiges Material kontinuierlich hindurchbewegt werden kann.

13. Vorrichtung nach einem oder mehreren der vorangehenden Ansprüche, **dadurch gekennzeichnet, daß** der Mikrowellenerzeuger (1) in oder nahe einer Stirnfläche der zuleitenden Kammer (2) angeordnet ist.

## Claims

1. Device for generating microwave plasmas, having a microwave generator (1), a plasma chamber (3) and a feeding chamber (2) with coupling points (6) in the wall between the feeding chamber (2) and plasma chamber (3), wherein the microwaves produced by the microwave generator (1) are introduced into said plasma chamber (3) via said feeding chamber (2) and via the said coupling sites (6), **characterized in that** said feeding chamber (2) is a resonator which is either constructed (a) as a cylinder resonator, or (b) as a curved or bent tube having a constant or non-constant diameter; and **in that** said plasma chamber (3) completely or partially encloses the feeding resonator (2).

2. Device according to claim 1, **characterized in that** feeding chamber (2) is a cylinder or a tube having a round, elliptical or angular cross-section.

3. Device according to claim 1 or 2, **characterized in that** said feeding chamber (2) and said plasma chamber (3) have the same length along a common axis.

4. Device according to claim 1 or 2, **characterized in that** said feeding chamber (2) and said plasma chamber (3) have different lengths along a common axis.

5. Device according to one of claims 1 to 4, **characterized in that** at least one of the end faces of the feeding chamber (2) and/or the plasma chamber (3) is arranged displaceably or/and rotatably in a variable fashion.

6. Device according to one or more of claims 1 to 5, **characterized in that** the common wall between the feeding chamber (2) and the plasma chamber (3) is constructed completely or partially in a multiple fashion, and **in that** at least one of the thus-formed walls of the said common wall, with the coupling points (6) located there, is arranged displaceably or/and rotatably in a variable fashion.

7. Device according to claim 6, **characterized in that** at least one of the thus-formed walls of the said common wall, with the coupling points (6) located there, is connected with an end face of the feeding chamber (2) and/or the plasma chamber (3), said end face being arranged displaceably or/and rotatably in a variable fashion.

8. Device according to one or more of the preceding claims, **characterized in that** said plasma chamber (3) is constructed as a resonator, preferably as a coaxial, rectangular or annular resonator.

9. Device according to one or more of the preceding claims, **characterized in that** the coupling sites (6) are configured so as to be variable, moveable and settable, and so that they can be be covered or be switched in.

10. Device according to one or more of the preceding claims, **characterized in that** said coupling sites (6) are designed as slots, preferably arranged in pairs or in rows.

11. Device according to any one of the preceding claims, **characterized in that** the plasma chamber (3) contains an evacuatable receptacle which consists completely or partially of a dielectric material.

12. Device according to one or more of the preceding claims, **characterized in that** the plasma chamber (3) has one or more slots through which a web-shaped material to be treated can be moved in a continuous fashion.

13. Device according to one or more of the preceding claims, **characterized in that** the microwave generator (1) is arranged in or near an end face of the feeding chamber (2).

## Revendications

1. Dispositif pour la production de plasmas micro-ondes, comprenant un générateur de micro-ondes (1), une chambre de plasma (3) et une chambre d'alimentation (2) avec des points de couplage (6) dans la paroi située entre la chambre d'alimentation (2) et la chambre de plasma (3), les micro-ondes du générateur de micro-ondes (1) étant injectées dans la chambre de plasma (3) en passant par la chambre d'alimentation (2) et lesdits points de couplage (6), **caractérisé en ce que** la chambre d'alimentation (2) est un résonateur réalisé soit (a) comme résonateur cylindrique soit (b) comme tube coudé ou incurvé de diamètre constant ou variable, et **en ce que** la chambre de plasma (3) entoure complètement ou partiellement le résonateur d'alimentation (2).

2. Dispositif selon la revendication 1, **caractérisé en ce que** la chambre d'alimentation (2) est un cylindre ou un tube de section circulaire, elliptique ou anguleuse.

3. Dispositif selon la revendication 1 ou 2, **caractérisé en ce que** la chambre d'alimentation (2) et la chambre de plasma (3) sont réalisées sur une même longueur le long d'un axe commun.

4. Dispositif selon la revendication 1 ou 2, **caractérisé en ce que** la chambre d'alimentation (2) et la chambre de plasma (3) sont réalisées sur une longueur différente le long d'un axe commun.

5. Dispositif selon l'une des revendications 1 à 4, **caractérisé en ce qu'**au moins une des faces frontales de la chambre d'alimentation (2) et / ou de la chambre de plasma (3) est placée de manière à être variablement déplaçable ou / et orientable.

6. Dispositif selon l'une ou plusieurs des revendications 1 à 5, **caractérisé en ce que** la paroi commune entre la chambre d'alimentation (2) et la chambre de plasma (3) est réalisée complètement ou partiellement comme paroi multiple et **en ce qu'**au moins l'une des parois ainsi formées de la paroi commune, avec les points de couplage (6) qui s'y trouvent, est variablement déplaçable ou / et orientable.

7. Dispositif selon la revendication 6, **caractérisé en ce qu'**au moins l'une des parois ainsi formées de la paroi commune, avec les points de couplage (6) qui s'y trouvent, est assemblée avec une face frontale variablement déplaçable ou / et orientable de la chambre d'alimentation (2) et / ou de la chambre de plasma (3).

8. Dispositif selon l'une ou plusieurs des revendications précédentes, **caractérisé en ce que** la chambre de plasma (3) est réalisée sous la forme d'un résonateur qui est de préférence un résonateur coaxial, rectangulaire ou annulaire.

9. Dispositif selon l'une ou plusieurs des revendications précédentes, **caractérisé en ce que** les points de couplage (6) sont réalisés de manière à être variables, mobiles, réglables, recouvrables ou à pouvoir être mis en marche par ouverture.

10. Dispositif selon l'une ou plusieurs des revendications précédentes, **caractérisé en ce que** les points de couplage (6) sont réalisés sous la forme de fentes qui sont disposées de préférence par paires ou en rangées.

11. Dispositif selon l'une ou plusieurs des revendications précédentes, **caractérisé en ce que** la chambre de plasma (3) contient un récipient pouvant être mis sous vide, lequel est composé entièrement ou partiellement d'un matériau diélectrique.

12. Dispositif selon l'une ou plusieurs des revendications précédentes, **caractérisé en ce que** la chambre de plasma (3) présente une ou plusieurs fentes par lesquelles peut passer en continu un matériau sous forme de bande à traiter.

13. Dispositif selon l'une ou plusieurs des revendications précédentes, **caractérisé en ce que** le générateur de micro-ondes (1) est placé dans ou à proximité d'une face frontale de la chambre d'alimentation (2).
